Europäisches Patentamt

European Patent Office

Office européen des brevets

(11) Publication number: **0 373 945 B1**

## EUROPEAN PATENT SPECIFICATION

(45) Date of publication of patent specification: **02.02.94** (51) Int. Cl.5: **G02F 1/015**, H01S 3/103

(21) Application number: **89313111.0**

(22) Date of filing: **14.12.89**

(54) **Phase modulation.**

(30) Priority: **14.12.88 GB 8829116**

(43) Date of publication of application:
**20.06.90 Bulletin 90/25**

(45) Publication of the grant of the patent:
**02.02.94 Bulletin 94/05**

(84) Designated Contracting States:
**AT BE CH DE ES FR GR IT LI LU NL SE**

(56) References cited:
EP-A- 0 263 613
WO-A-86/07657

APPLIED PHYSICS LETTERS, vol. 50, no. 15,
13th April 1987, pages 947-949, American
Institute of Physics; J.M. LIU et al.: "Carrier-
induced phase shift and absorption in a
semiconductor laser waveguide under cur-
rent injection"

ELECTRONICS LETTERS, vol. 18, no. 5, 4th
March 1982, pages 210-211; S. KOBAYASHI et
al.: "Optical phase modulation in an injec-
tion locked AiGaAs semiconductor laser"

(73) Proprietor: **BRITISH TELECOMMUNICATIONS
public limited company
81 Newgate Street
London EC1A 7AJ(GB)**

(72) Inventor: **Mellis, John
19 Grove Road
Brantham
Manningtree Colchester CO11 1TX(GB)**

(74) Representative: **Dutton, Erica L. G. et al
BRITISH TELECOM
Intellectual Property Unit
13th Floor
151, Gower Street
London, WC1E 6BA (GB)**

Rank Xerox (UK) Business Services
(3.10/3.09/3.3.3)

ELECTRONICS LETTERS, vol. 20, no. 17, 16th August 1984, pages 706-707; R.P. WEBB et al.: "Travelling-wave laser amplifier experiments at 1-5mum"

ELECTRONICS LETTERS, vol. 24, no. 25, 8th December 1988, pages 1550-1552; T.G. HODGKINSON et al.: "Application of communications theory to analyse carrier density modulation effects in travelling-wave semiconductor laser amplifiers"

JOURNAL OF OPTICAL COMMUNICATIONS, vol. 4, no. 2, 1983, pages 51-62; J.C. SIMON: "Semiconductor laser amplifier for single mode optical fiber communications"

ELECTRONICS LETTERS 21, no. 23, pp. 1076-1077 (1985)

"GUIDED-WAVE OPTOELECTRONICS", pp. 294-307, T. Tamir (Ed.), Springer-Verlag (1988/1990)

## Description

This invention relates to modulation and especially to phase modulation of laser amplifiers.

Presently there is much attention being given to development of coherent optical transmission systems. It is often preferred to utilise phase modulation and for this purpose most of the proposed systems utilise lithium niobate phase modulators. A disadvantage of lithium niobate modulators is that there is an attendant loss of several dB and it is therefore desirable to amplify the signal after modulation in order to compensate for this loss. Travelling wave or near travelling wave amplifiers have been used for this purpose, however the need to utilise both a modulator and an amplifier leads to increase in cost and sensitivity penalties.

In a paper by KOBAYASHI et al, published in Electronics Letters Volume 18, no. 5, 4.3.82, pp 210-211, there is disclosed phase modulation in an arrangement employing two lasers in an optically injection-locked semiconductor laser oscillator arrangement.

The present invention is directed towards providing phase modulation by direct modulation of a laser amplifier.

According to a first aspect of the present invention, there is provided a phase modulator comprising a semiconductor travelling wave laser amplifier having an optical input and an optical output through which input and output an optical travelling wave propagates in use of the amplifier without substantial reflection, injection bias current input means arranged to provide a DC bias current below the laser threshold and modulation bias current input means arranged to impose a modulation signal on the DC bias current to provide a phase modulated optical output.

According to a second aspect of the present invention, there is provided a method of providing a phase shift keyed modulation of an optical signal comprising providing a DC injection bias current to a laser amplifier, said current being below the lasing threshold for the amplifier and the amplifier being a travelling wave laser amplifier through which an optical travelling wave propagates in use without substantial reflection, inputting an optical carrier signal to said travelling wave laser amplifier and phase modulating the carrier signal by applying a modulation to the refractive index of at least the active region of the laser amplifier by applying a modulation signal to the injection bias current of the laser amplifier.

The expression "optical" as used in the present specification should be construed as including wavelengths in and beyond the visible spectrum, and to include wavelengths generated by and detectable by semiconductor devices.

The expression 'travelling wave amplifier' refers to the type of laser amplifier in which the facets are antireflection coated in order to minimise reflection within the laser cavity, the expression is to be construed to include so called 'near travelling wave amplifiers' in which there remains a residual facet reflectivity, typically resulting in a 3 dB gain ripple but not limited to a 3 dB gain ripple maximum since for some applications greater gain ripple may be tolerated.

The invention is now described by way of example with reference to the accompanying drawings in which:

Figure 1 is a schematic diagram of a modulation circuit according to a preferred embodiment of the invention;

Figure 2 is a schematic illustration of phase modulation versus modulation frequency for an embodiment of the invention;

Figure 3 is a plot of alpha, the ratio of the change in the real part of the refractive index to the change in the imaginary part, and gain against laser amplifier bias current;

Figure 4 is a plot of m, the intensity modulation index, and alpha against laser amplifier bias current; and

Figure 5 is a plot of alpha and the phase modulation index against laser amplifier bias current.

In a semiconductor laser amplifier output power is produced by electron-hole recombination in response to an input light (optical) signal. The carrier density in the amplifier is a function of the applied bias current and in laser amplifiers the bias current is typically set at about 70 percent of the lasing bias threshold in order to give maximum bandwidth. A change in carrier density in semiconductor materials also brings about a change in the refractive index, and the present invention proposes modulating the bias current in order to modulate the refractive index and produce phase modulation of the output signal from a travelling wave amplifier, thus enabling use of a travelling wave laser as a phase modulator.

Initially this technique appears to have limitations because the variation in bias current would also be expected to give an amplitude modulation in the output giving rise to complexity problems in the ultimate receiver. Also, whereas under lasing conditions minority carrier lifetime is shortened by stimulated emission resulting from the high photon level, in a travelling or near travelling wave laser amplifier the photon level and stimulated emission are lower and the carrier lifetime is dominated by non radiative effects. On this basis a modulation frequency of less than 1 GHz would be expected.

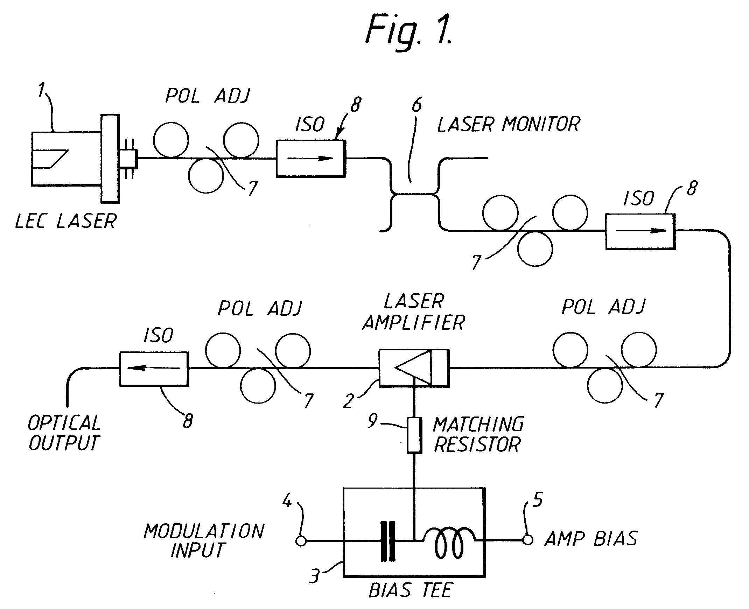

Figure 1 shows a schematic test circuit for phase modulating a laser amplifier in accordance with the invention, the circuit comprising a transmitter laser 1, a laser amplifier 2, and a bias tee 3 at which a modulation bias current is input on line 4 and is superimposed on the amplifier dc bias current input on line 5, the combined modulated bias being applied to the laser amplifier via a matching resistor 9. The transmitter laser output passes through a two way coupler 6 at which the transmitter laser output is monitored. Polarisation adjusters 7 are provided in each branch of the circuit as the various elements are generally polarisation sensitive, but with plarisation insensitive elements these could clearly be omitted. The input and output of the laser amplifier 2 and the output of the transmitter laser are provided with optical isolators 8. At the laser amplifier the output is phase modulated due to the refractive index changes induced in the amplifier by superimposition of the varying modulation input bias on the dc amplifier bias. The modulation of the bias current is output as a phase modulation because of the travelling wave nature of the amplifier. A change in the refractive index in a laser cavity alters the number of wavelengths (or part wavelengths) accommodated in the cavity length. In a laser with reflective facets this results in a change in the standing wave and therefore a change in the output wavelength. However in a travelling wave amplifier the wave continues propagation out of the amplifier (without substantial reflection) and the output light is phase shifted by the apparent change in path length caused by the refractive index change. The refractive index change is applied over the active region by virtue of modulation of the injection current, however some modulation of the confinement region may occur.

Since the losses in the system prior to the laser amplifier are not excessive, totalling perhaps only 2dB in a dedicated system in which there may only be an isolator between the transmission layer and laser amplifier, compared with over 10 dB for systems utilising lithium niobate modulators it is not necessary to run the amplifier at maximum gain, and therefore for some applications it is preferable to set the dc bias and input optical power so that the gain is saturated. Under these conditions the amplifier gain is of the order of 4 dB compared with a possible 13 to 15 dB for low input optical power and unsaturated gain. Two advantages result from modulating under saturation conditions: firstly due to the saturation and relatively low gain the residual amplitude modulation is small because the output amplitude is comparatively insensitive to the small bias changes of the modulation signal, and secondly the modulation frequency response is more rapid due to the carrier lifetime being shortened because of the greater level of stimulated emission at saturation.

A prototype modulator circuit was tested in the arrangement shown in Figure 1. The transmission laser 1 was a miniature grating external cavity laser providing a spectral linewidth of about 10 KHz at 1530 nm, giving incident optical power to the laser amplifier of -19 dBm. An indium gallium arsenide phosphide laser amplifier 2 was used with a 25 mA bias current providing a fibre - fibre gain of 4 dB. The laser amplifier had single layer antireflection coatings on both facets providing residual reflectivity of less than 0.3 percent.

A sinewave modulation was used as the input modulation bias and a scanning Fabry Perot interferometer was used to observe the output modulation from the laser amplifier, phase modulation being observable as changes in the relative intensities of the modulation sidebands. Residual amplitude modulation could also be observed as asymmetry in the intensities of the modulation sidebands.

Assuming that the sub-threshold dependence of refractive index on carrier density is

$$dn/dN = -1 \times 10^{-20} cm^3$$

where n = refractive index
N = number of carriers per $cm^3$
and using an empirical value for the rate of change of carriers with injection current I of

$$dN/dl = 8 \times 10^{16} cm^{-3} mA^{-1}$$

then the dependence of refractive index on injection current is

$$dn/dl = -8 \times 10^{-4} mA^{-1}$$

In an amplifier of length L = 500 microns the current change required for a phase shift of $\pi$ at a wavelength $\lambda$o of 1500 nm is given by

$$I_\pi = (\lambda o/2L)/(dn/dl) = 1.9 \text{ mA}$$

Thus it is predicted that a modulation of the order of 2 mA on the bias current would provide a phase shift of 180°.

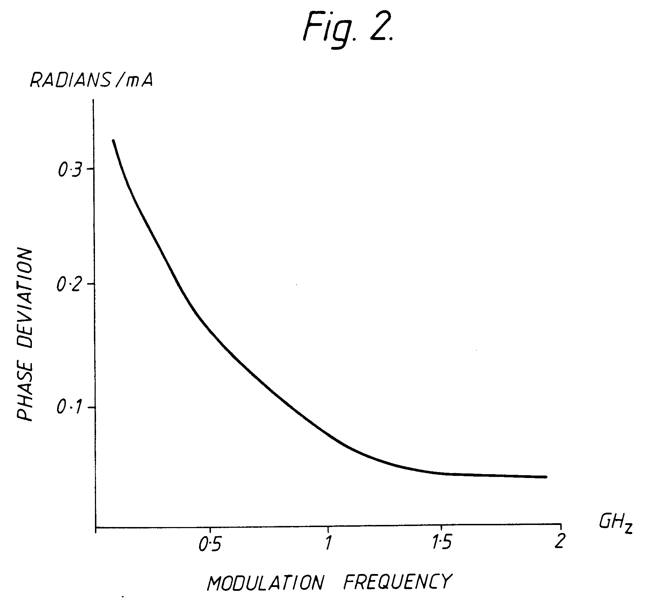

In practice it was found that with the circuit of Figure 1 a current modulation an order of magnitude above the prediction was required with 26 mA modulation being required for a $\pi$ peak to peak phase shift at 600 MHz. The phase shift achieved depended upon the modulation frequency and this is shown in Figure 2. It is likely that the results may be improved in terms of obtaining better high frequency response by modification of the packaging, but nevertheless the initial results from a non dedicated package demonstrate significant phase modulation efficiencies of 0.1 to 0.3 radians per mA were achieved for modulation frequencies in the range of 100 MHz to 2 GHz.

The residual amplitude modulation was calculated from measurement of modulation sidebands using the Bessel function

$$E(t) = E_o (1 + m. \sin (W_m t)) \sin [W_o t + \Delta \phi \sin W_m t)]$$

where:

E      is the field amplitude of the modulated signal

m      is the amplitude modulation index

$\Delta \phi$      is the phase deviation

$W_m$      is modulation frequency

The worst case AM index is given by:

$$m = 0.655 [(R - 1)/(R + 1)]$$

where R is the ratio of the upper to lower sideband intensities.

Applying these expressions to spectra observed using the scanning Fabry-Perot interferometer showed residual amplitude modulation of the order of 0.05 in a modulation power of + 7 dBm, at a current modulation of 26 mA with a $\pi$ peak to peak phase shift at 600 MHz modulation frequency.

From these results it is demonstrated that modulation frequencies in excess of those that might be expected and supression of amplitude modulation are achievable by modulation of a travelling wave amplifier under saturation conditions. For some applications, for example where relatively low frequency (e.g. less than 1 GHz) modulation and/or significant amplitude modulation can be tolerated the amplifier may be operated to provide higher gain and not under saturated gain conditions.

We have discovered, very surprisingly, that although low facet reflectivity is necessary, there is nevertheless an advantage in having some residual reflectivity, of say from 0.1 to 0.3 percent.

Specifically, we have discovered that there is a cyclical variation in residual amplitude modulation for a given phase modulation with a linear variation in amplifier bias current, and that this means that it possible to achieve much lower levels of amplitude modulation than would otherwise be expected, merely by selecting an appropriate bias current level such that the amplifier operates at a low point in the AM/bias current curve.

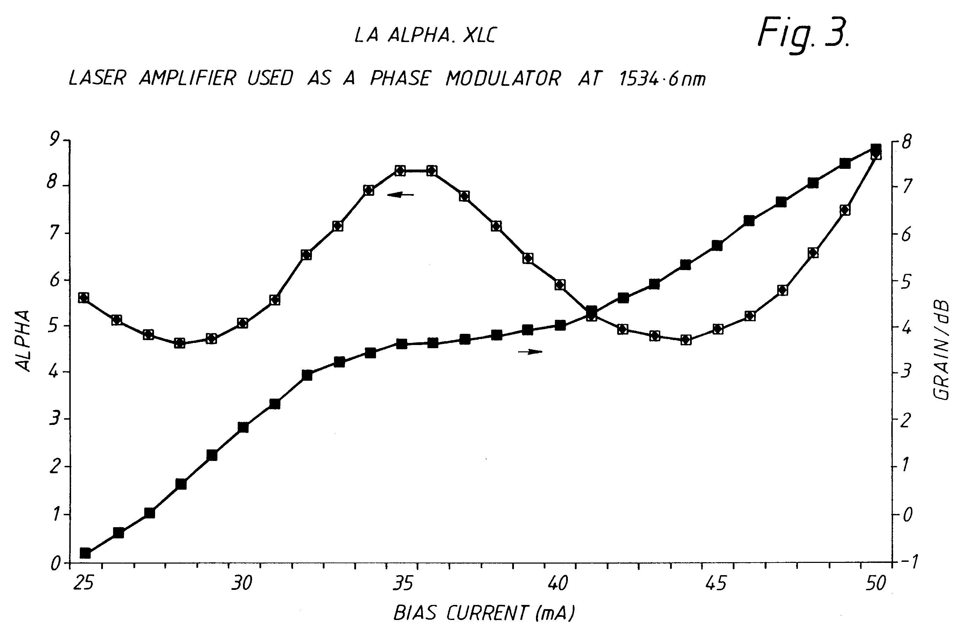

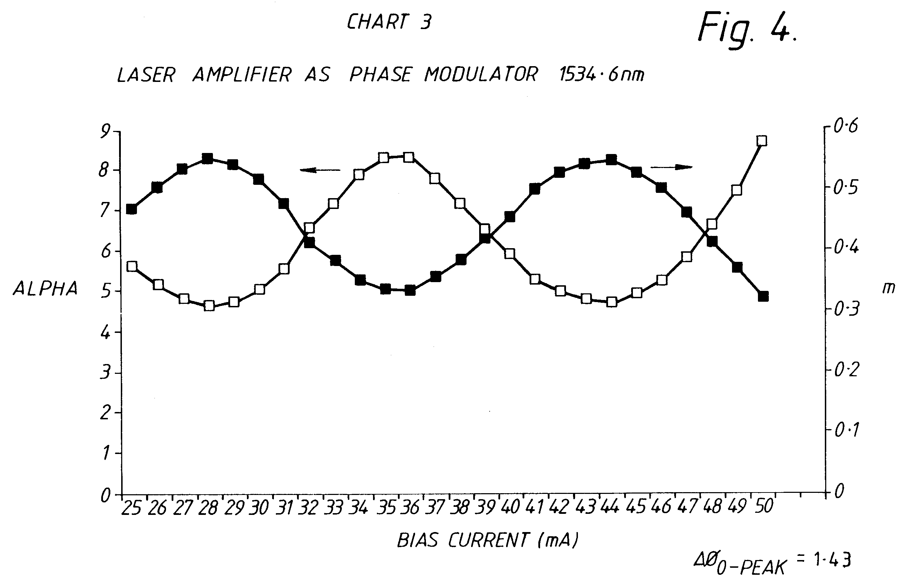

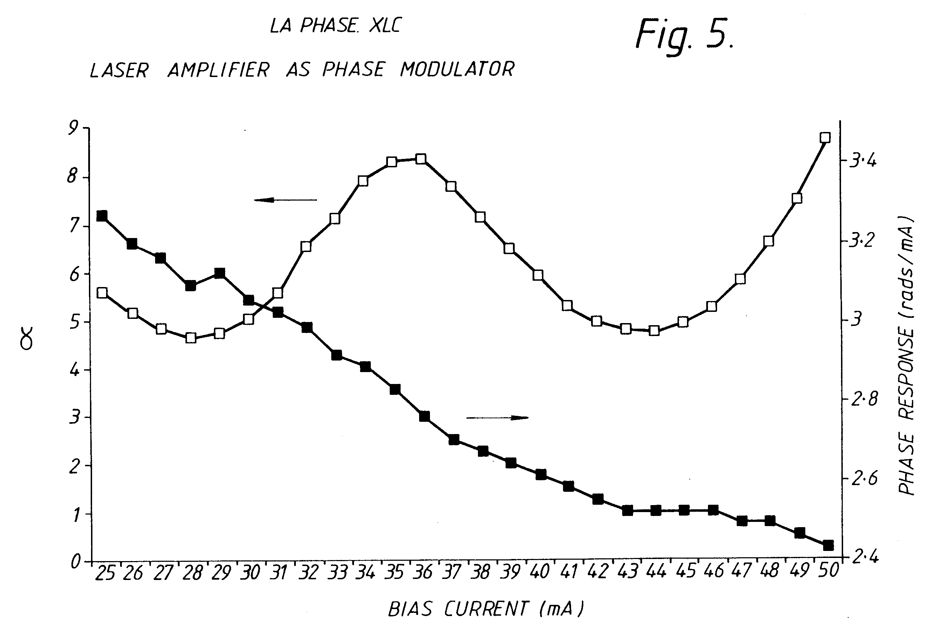

This behaviour is illustrated in Figures 3, 4 and 5. In Figure 3, a parameter alpha is shown to fluctuate cyclically with respect to bias current while gain increases. Alpha is defined as the ratio of the changes in the real part of the refractive index to the changes in the imaginery part (gain or loss). A large alpha corresponds to a small level of intensity modulation - as illustrated in Figure 4, in which m is the intensity modulation index, m = 0.5 for a 50 percent or 3dB optical power change. Figure 5 shows the alpha data plotted with the phase modulation index which falls monotonically with increasing bias.

In a further preferred embodiment, the level of amplitude modulation transmitted is further limited through the use of a gain saturated region between the output of the modulating laser amplifier and the port through which the output signals are launched (which will normally be an optical fibre). The gain saturated region or device operates as an optical limiter. The gain saturated region may be a separate laser amplifier operated in a saturated regime, but is more preferably formed as a region of a monolithically integrated device which also comprises the modulating laser amplifier. In such a monolithically integrated device the waveguide layer is preferably continuous, just the top (ie. remote from the substrate) contact layer(s) being divided so that control currents can be fed to the two device parts independently. Typically with such a device the modulating section would be biased to a high level, while the limiting section ("downstream" of the modulating section) would be biased to a much lower level and operated in a saturation regime. Similar biasing arrangements would apply even when two separate, ie non-integrated, devices are used.

Finally, it is worth noting that there is no requirement for the modulating laser amplifier to be accurately wavelength matched to the optical source, it is only necessary that the source wavelength be within the gain profile of the modulating device.

## Claims

1. A phase modulator comprising a semiconductor travelling wave laser amplifier having an optical input and an optical output through which input and output an optical travelling wave propagates in use of the amplifier without substantial reflection, injection bias current input means arranged to provide a DC bias current below the laser threshold and modulation bias current input means arranged to impose a modulation signal on the DC bias current to provide a phase modulated optical output.

2. A phase modulator according to claim 1 in which the laser is operated under saturated conditions.

3. A phase modulator as claimed in claim 1 wherein the laser amplifier has residual facet reflectivities which give rise to cyclical variations in residual amplitude modulation of an optical output with changes in the injection bias current.

4. A phase modulator as claimed in claim 3 wherein the facet reflectivities are in the range 0.1 to 0.3 percent inclusive.

5. A phase shift keyed optical communications system comprising a phase modulator according to any one of claims 1 to 4.

6. A phase shift keyed optical communications system as claimed in claim 5 as dependent on claim 3 or claim 4 wherein the laser amplifier is operated at a bias current which corresponds to a minimum or near-minimum in a plot of amplitude modulation against drive current.

7. A method of providing a phase shift keyed modulation of an optical signal comprising providing a DC injection bias current to a laser amplifier, said current being below the lasing threshold for the amplifier and the amplifier being a travelling wave laser amplifier through which an optical travelling wave propagates in use without substantial reflection, inputting an optical carrier signal to said travelling wave laser amplifier and phase modulating the carrier signal by applying a modulation to the refractive index of at least the active region of the laser amplifier by applying a modulation signal to the injection bias current of the laser amplifier.

8. A method of modulation according to claim 7 in which the optical signal strength input to the amplifier is arranged to saturate the gain of the amplifier.

9. A method of modulation according to claim 8 in which saturation is achieved by adjustment of the dc level of the injection bias current to the laser amplifier.

**Patentansprüche**

1. Phasenmodulator, der aufweist: einen Wanderwellen-Halbleiterlaserverstärker mit einem optischen Eingang und einem optischen Ausgang, durch welchen Eingang und Ausgang sich eine optische Wanderwelle bei Verwendung des Verstärkers ohne wesentliche Reflexion ausbreitet, eine Vorspann-Injektionsstrom-Eingabeeinrichtung, die angeordnet ist, um einen DC-Vorspannstrom unterhalb der Laserschwelle bereitzustellen, und eine Modulationsvorspannstrom-Eingabeeinrichtung, die angeordnet ist, um ein Modulationssignal auf den DC-Vorspannstrom aufzuprägen, um eine phasenmodulierte optische Ausgabe bereitzustellen.

2. Phasenmodulator nach Anspruch 1, bei dem der Laser unter Sättigungsbedingungen betrieben wird.

3. Phasenmodulator nach Anspruch 1, wobei der Laserverstärker restliches Facettenreflexionsvermögen aufweist, die zyklische Variationen in einer Restamplitudenmodulation einer optischen Ausgabe mit Änderungen im Injektionsvorspannstrom mit sich bringen.

4. Phasenmodulator nach Anspruch 3, wobei die Facettenreflexionsvermögen im Bereich von 0,1 bis 0,3 % einschließlich sind.

5. Optisches Kommunikationssystem mit Phasenumtastung, das einen Phasenmodulator nach einem der Ansprüche 1 bis 4 aufweist.

6. Optisches Kommunikationssystem mit Phasenumtastung nach Anspruch 5, wenn abhängig von Anspruch 3 oder Anspruch 4, wobei der Laserverstärker bei einem Vorspannstrom betrieben wird, der einem Minimum oder nahe einem Minimum in einer Kurve Amplitudenmodulation gegenüber Treiberstrom entspricht.

7. Verfahren zum Bereitstellen einer Phasenumtastmodulation eines optischen Signals, wobei das Verfahren aufweist: Bereitstellen eines DC-Injektionsvorspannstroms an einen Laserverstärker, wobei der Strom unterhalb der Laserschwelle für den Verstärker ist und wobei der Verstärker ein Wanderwellen-Laserverstärker ist, durch den sich eine optische Wanderwelle bei Verwendung ohne wesentliche Reflexion ausbreitet, Eingeben eines optischen Trägersignals an den Wanderwellen-Laserverstärker und Phasenmodulieren des Trägersignals durch Anwenden einer Modulation auf den Brechungsindex von zumindest dem aktiven Bereich des Laserverstärkers, indem ein Modulationssignal an den Injektionsvorspannstrom des Laserverstärkers angelegt wird.

8. Verfahren zur Modulation nach Anspruch 7, bei dem die optische Signalstärke, die an dem Verstärker eingegeben wird, eingerichtet ist, um die Verstärkung des Verstärkers zu sättigen.

9. Verfahren zur Modulation nach Anspruch 8, bei dem eine Sättigung durch Einstellen des DC-Pegels des Injektionsvorspannstroms zu dem Laserverstärker erreicht wird.

## Revendications

1. Un modulateur de phase comprenant un amplificateur laser à semi-conducteur à ondes progressives, comportant une entrée optique et une sortie optique, entrée et sortie à travers lesquelles une onde progressive optique se propage sans réflexion sensible lors de l'utilisation de l'amplificateur, un moyen d'entrée de courant de polarisation d'injection agencé de façon à amener un courant continu de polarisation inférieur au seuil de laser, et un moyen d'entrée de courant de polarisation de modulation agencé de manière à imposer un signal de modulation sur le courant de polarisation en courant continu afin de produire une sortie optique modulée en phase.

2. Un modulateur de phase selon la revendication 1 dans lequel le laser est mis en oeuvre dans des conditions saturées.

3. Un modulateur de phase selon la revendication 1 dans lequel l'amplificateur laser présente des réflectivités résiduelles de facettes qui donnent naissance à des variations cycliques de la modulation d'amplitude résiduelle d'une sortie optique, lorsque le courant de polarisation d'injection varie.

4. Un modulateur de phase selon la revendication 3 dans lequel les réflectivités des facettes sont comprises dans la plage de 0,1 à 0,3 pour cent inclus.

5. Un système de communication optique à modulation par déplacement de phase comprenant un modulateur de phase selon l'une quelconque des revendications 1 à 4.

6. Un système de communications optiques à modulation par déplacement de phase selon la revendication 5, lorsqu'elle dépend de la revendication 3 ou de la revendication 4, dans laquelle l'amplificateur laser est mis en oeuvre à un courant de polarisation qui correspond à un minimum ou presque à un minimum du tracé de modulation d'amplitude en fonction du courant d'excitation.

7. Un procédé de réalisation d'une modulation par déplacement de phase d'un signal optique comprenant les étapes consistant à amener à un amplificateur laser un courant de polarisation d'injection en courant continu, ledit courant étant inférieur au seuil d'effet laser de l'amplificateur et l'amplificateur étant un amplificateur laser à ondes progressives à travers lequel une onde progressive optique se propage sans réflexion sensible en utilisation, introduire un signal de porteuse optique dans ledit amplificateur laser à ondes progressives et moduler en phase le signal de porteuse en appliquant une modulation à l'indice de réfraction d'au moins la zone acquise de l'amplificateur laser en appliquant un signal de modulation au courant de polarisation d'injection de l'amplificateur à laser.

8. Un procédé de modulation selon la revendication 7 dans lequel l'intensité du signal optique entré dans l'amplificateur est agencé de manière à saturer le gain d'amplificateur.

9. Un procédé de modulation selon la revendication 8 dans lequel une saturation est atteinte par un ajustement du niveau de courant continu du courant de polarisation d'injection envoyé à l'amplificateur laser.

Fig. 1.

# Fig. 2.

LA ALPHA. XLC                                          Fig. 3.

LASER AMPLIFIER USED AS A PHASE MODULATOR AT 1534·6 nm

BIAS CURRENT (mA)

ALPHA

GRAIN/dB

EP 0 373 945 B1

CHART 3

Fig. 4.

LASER AMPLIFIER AS PHASE MODULATOR 1534·6nm

ALPHA

BIAS CURRENT (mA)

$\Delta\emptyset_{0-PEAK} = 1·43$

EP 0 373 945 B1

LA PHASE. XLC

Fig. 5.

LASER  AMPLIFIER  AS  PHASE  MODULATOR

BIAS CURRENT (mA)

PHASE RESPONSE (rads/mA)